# EUROPÄISCHE PATENTSCHRIFT

(11) **EP 2 823 514 B1**
(45) Veröffentlichungstag und Bekanntmachung des Hinweises auf die Patenterteilung: **28.09.2016**
(21) Anmeldenummer: 13709078.3
(22) Anmeldetag: 08.03.2013
(51) Int. Cl.: H01L 31/0687, H01L 31/18

(54) **MEHRFACHSOLARZELLE UND DEREN HERSTELLUNGSVERFAHREN**
MULTIJUNCTION SOLAR CELL AND FABRICATION METHOD THEREOF
CELLULE SOLAIRE MULTIJONCTION ET SON PROCEDE DE FABRICATION

(30) Priorität: 08.03.2012 DE 102012004734
(43) Veröffentlichungstag der Anmeldung: 14.01.2015
(73) Patentinhaber: Fraunhofer Gesellschaft zur Förderung der angewandten Forschung e.V., 80686 München (DE)
(72) Erfinder: DIMROTH, Frank, 79194 Gundelfingen (DE); BETT, Andreas, W., 79114 Freiburg (DE)
(74) Vertreter: Weishäupl, Michael
(86) Internationale Anmeldenummer: PCT/EP2013/054754
(87) Internationale Veröffentlichungsnummer: WO 2013/132073

(56) Entgegenhaltungen:
- EP-A2- 1 109 230
- US-A1- 2006 185 582
- US-A1- 2010 116 327
- US-A1- 2012 285 520

## Beschreibung

Die vorliegende Erfindung betrifft eine Mehrfachsolarzelle mit mindestens vier pn-Übergängen. Die einzelnen Teilzellen weisen dabei Bandlücken von 1,9 eV, 1,4 eV, 1,0 eV und 0,7 eV auf. Die erfindungsgemäßen Mehrfachsolarzellen finden Anmeldung im Weltraum sowie in terrestrischen Konzentratorsystemen.

Es ist bekannt, dass so genannte Mehrfachsolarzellen davon profitieren, wenn die Anzahl der Teilzellen erhöht werden kann. Wichtig ist dabei allerdings neben der Anzahl der Teilzellen die so genannte Bandlückenenergien der Materialien. Diese müssen optimal an das Sonnenspektrum angepasst werden. Die heute besten Solarzellen bestehen aus drei pn-Übergängen in den Materialien Gallium-Indium-Phosphid (GaInP), Gallium-Indium-Arsenid (GaInAs) und Germanium. Die Materialien können gitterangepasst zueinander gewachsen werden.

Es ist seit langem bekannt, dass die Effizienz dieser Solarzellen deutlich erhöht werden kann, indem eine zusätzliche Teilzelle zwischen der GaInAs-Teilzelle und der Germanium-Teilzelle eingesetzt wird. Diese Teilzelle sollte idealerweise eine Bandlückenenergie von etwa 1,0 eV besitzen. Problematisch ist, dass kein bekannter Halbleiter mit hoher Materialqualität und mit der Gitterkonstante von Galliumarsenid (GaAs) oder Germanium diese Anforderung erfüllt. Aus diesem Grund werden heute eine Vielzahl neuer Fertigungsmethoden und Konzepte diskutiert, um dieses Problem zu lösen. Dazu gehören
- Konzepte, bei denen die Solarzellenstruktur in invertierter Reihenfolge gewachsen wird,
- Konzepte bei denen die Solarzellenstruktur auf einer anderen Gitterkonstante aufgebaut wird,
- Konzepte bei denen neue Materialien wie die verdünnten Nitride eingesetzt werden sowie
- Konzepte bei denen Wafer Bonding eingesetzt wird.

Ziel ist es daher im Stand der Technik, eine Vierfachsolarzelle mit optimaler Bandlückenenergie für das AM1.5 bzw. AM0 Sonnenspektrum zu entwickeln. Die optimalen Bandlückenenergien liegen dabei im Bereich von: 1,9 eV/1,4 eV/1,0 eV/0,7 eV.

Es gibt verschiedene Ansätze zur Herstellung solcher III-V-Mehrfachsolarzellen mit vier pn-Übergängen. Die wichtigsten sollen im Folgenden kurz erläutert werden:

### $1. GaInP/GaInAs/GaInNAs/Ge Solarzelle:

Dieser Typ einer Vierfachsolarzelle baut auf der herkömmlichen Epitaxie von III-V-Mehrfachsolarzellen auf Germaniumsubstrat auf. Einzige Änderung zum heutigen Stand der Technik ist die Integration einer zusätzlichen Teilzelle aus dem verdünnt stickstoffhaltigen Material Gallium-Indium-Nitrid-Arsenid (GaInNAs), Alternativ zu GaInNAs können auch Halbleiter wie Gallium-Nitrid-Arsenid-Antimonid (GaNAsSb) oder Bor-Gallium-Indium-Arsenid (BGaInAs) eingesetzt werden. Die Konzentration von N bzw. B liegt im Bereich von 2-4 %. So können III-V-Verbindungen hergestellt werden, welche eine Bandlückenenergie von 1,0 eV aufweisen und gitterangepasst zu Germanium gewachsen werden können. Das große Problem bei diesem Ansatz ist die Materialqualität der verdünnt N- (bzw. B)-haltigen Materialien. Bisher ist es nicht möglich gewesen Solarzellen mit hoher Effizienz und gleichzeitig mit dem heute verbreiteten Verfahren der metallorganischen Gasphasenepitaxie herzustellen. Gute Ergebnisse wurden allerdings bei Wachstum mittels Molekularstrahl-Epitaxie erreicht. Diese Methode zeichnet sich allerdings durch deutlich höhere Herstellungskosten für die Solarzellen aus und findet daher heute keine Anwendung in der industriellen Produktion. Ein Wachstum der GaInP/GaInAs/GaInNAs/Ge-Solarzellen mittels metallorganischer Gasphasenepitaxie ist momentan nicht in Sicht. In Publikationen von Volz et al. und Friedman et al, werden Solarzellen von diesem Typ beschrieben (Volz, K. et al., Optimization of annealing conditions of (GaIn)(NAs) for solar cell applications, Journal of Crystal Growth, 2008, 310 (7-9): p. 2222-8 sowie Volz et al., Development and optimization of a 1 eV (GaIn)(NAs) solar cell, in Proceedings of the 34th IEEE Photovoltaic Solar Energy Conference, 2009, Philadelphia, USA sowie Friedman, D.J., et al. 0,7-eV GaInAs Junction for a GaInP/GaAs/GaInAs (1 e V)/GaInAs (0.7 eV) Four-Junction Solar Cell, in Proceedings of the 4th World Conference on Photovoltaic Energy Conversion, 2006, Waikoloa, Hawaii, USA).

### 2. GaInP/GaAs/GaInAsP/GaInAs Solarzelle:

Bei diesem Typ einer Vierfachsolarzelle wird die eine Hälfte der Struktur auf ein Galliumarsenid-Substrat gewachsen und die andere Hälfte auf ein Indium-Phosphid-Substrat. Es können prinzipiell die gewünschten Bandlücken der Materialien erreicht werden. Bei diesem Konzept wird der obere und untere Teil der Struktur über einen Wafer-Bond oder über mechanisches Stapeln verbunden. Der Nachteil dieser Struktur besteht darin, dass die untere Teilzelle auf einem Indium-Phosphid-Substrat gewachsen werden muss. Dieses Substrat ist extrem teuer (die Kosten liegen etwa 8-10 mal höher im Vergleich zu Germanium und Gailliumarsenid). In der Publikation von Bhusari et al. werden Solarzellen dieses Typs beschrieben (Bhusari, D., et al., Direct semiconductor bonding technology (SBT) for high efficiency III-V multi-junction solar cells, in Proceedings of the 37th IEER Photovoltaic Specialisis Conference, 2011, Seattle, Washington, USA).

### 3. Invertierte GaInP/GaAs/GaInAs/GaInAs Solarzelle:

Bei diesem Konzept werden alle Teilzellen invertiert auf einem Galliumarsenid- oder Germanium-Substrat aufgewachsen. Danach wird die Struktur auf ein Substrat zur Stabilisierung übertragen, das Galliumarsenid- bzw. Germanium-Substrat entfernt und die Solarzelle prozessiert. Die niedrigen Bandlückenenergien von GaInAs im Bereich von 1,0 eV und 0,7 eV erfordern das Wachstum von metamorphen Pufferschichten mit einer sehr hohen Verspannung, Hierdurch entstehen zahlreiche Versetzungen, welche einen Einfluss auf den Wirkungsgrad der Solarzelle haben. Weiter hat sich herausgestellt, dass das GaInAs-Material für die Weltraumanwendung weniger geeignet ist, da die Solarzellen unter der Bestrahlung mit hochenergetischen Elektronen und Protonen schneller degradieren. In Friedman et al. werden Solarzellen dieses Typs beschrieben (Friedman, D.J., et al. 0,7-eV GaInAs Junction for a GaInP/GaAs/GaInAs (1 e V)/GaInAs (0.7 e V) Four-Junction Solar Cell, in Proceedings of the 4th World Conference on Photovoltaic Energy Conversion, 2006, Waikoloa, Hawaii, USA).

Weitere Ansätze aus der Technik zur Herstellung von III-V-Mehrfachsolarzellen mit mindestens vier pn-Übergängen gehen aus der US 2006/0185582 A1 und der US 2010/0116327 A1 hervor.

In der US 2006/0185582 A1 wird beschrieben wie 4- oder 5-fach Solarzellen durch das Übertragen dünner Halbleiterschichten auf z.B. Germanium hergestellt werden können. Es wird beschrieben wie eine 5-fach Solarzelle bestehend aus einer Kombination von GaInP/GaInAsP und InP/GaInAsP/GaInAs Solarzellen mittels Waferbonden realisiert werden kann. Dabei werden die Epitaxieschichten jeweils gitterangepasst zu einem mittels aufwändiger und teurer Prozesse hergestellten virtuellen Substrat wie InP/Ge abgeschieden. Die Solarzellenstrukturen werden anschließend gebondet und eines der virtuellen Substrate entfernt. Es handelt sich um einen sehr aufwändigen Prozess, bei welchem mehrfach dünne Schichten von einem Substrat auf ein anderes übertragen werden müssen.

In der US 2010/0116327 A1 wird eine 4-fach Solarzelle durch Bonden einer invertiert metamorph gewachsenen GaInP/GaAs/GaInAs Dreifachsolarzelle auf eine Germanium Zelle hergestellt. Hierbei befindet sich zwischen der GaAs und GaInAs Teilzelle ein metamorpher Puffer, um die Gitterkonstante zu vergrößern sowie eine Tunneldiode, um die Teilzellen zu verschalten. Dies hat den Nachteil, dass ein Teil des Spektrums, das von der zweiten Zelle absorbiert werden soll, bereits durch die Pufferschicht absorbiert wird. Des Weiteren wird in diesem Aufbau eine erhöhte mechanische Belastung der obersten Teilzellen und Tunneldioden während des Wachstums der Pufferschicht und der GaInAs Teilzelle bei den typischerweise vorliegenden Temperaturen von 600-700°C beobachtet. Dies führt zu einer Degradation der Tunneldioden und erhöhten Widerständen (D. Jung et al., AIGaAs/GaInP heterojunction tunnel diode for cascade solar cell application, J. Appl. Phys., 74, 2090, 1993). Beide Effekte bewirken, dass die Effizienz der Solarzelle sinkt. Ausgehend hiervon war es Aufgabe der vorliegenden Erfindung, ein Verfahren zur Herstellung von Mehrfachsolarzellen bereitzustellen, das einfach zu handhaben ist und mit herkömmlichen epitaktischen Verfahren kombinierbar ist. Gleichzeitig sollen die erfindungsgemäßen Mehrfachsolarzellen Bandlücken von 1,9 eV, 1,4 eV, 1,0 eV und 0,7 eV aufweisen und dabei gleichzeitig eine verbesserte Strahlungsstabilität zeigen.

Diese Aufgabe wird durch die Mehrfachsolarzelle mit den Merkmalen des Anspruchs 1, das Verfahren zur Herstellung der Mehrfachsolarzelle mit den Merkmalen der Ansprüche 11 und 12 gelöst. Der abhängige Anspruch 13 zeigt vorteilhafte Weiterbildungen auf. In Anspruch 14 werden erfindungsgemäße Verwendungen der Mehrfachsolarzelle genannt.

Erfindungsgemäß wird eine Mehrfachsolarzelle mit mindestens vier pn-Übergängen enthaltend eine erste, rückseitige und einen pn-Übergang aufweisende Germanium-Teilzelle, eine zweite und eine dritte Teilzelle aus III-V-Halbleitern sowie mindestens eine weitere, frontseitige Teilzelle aus III-V-Halbleitern bereitgestellt.

Eine erfindungsgemäße Mehrfachsolarzelle zeichnet sich dadurch aus, dass die zweite Teilzelle eine Gitterkonstante aufweist, die um mindestens 1 % größer ist als die Gitterkonstanten aller anderen Teilzellen und die zweite Teilzelle mit den benachbarten Teilzellen über eine metamorphe Pufferschicht zur Anpassung der Gitterkonstanten der benachbarten Teilzellen und auf der gegenüberliegenden Seite der zweiten Teilzelle über eine Waferbond-Verbindung mit der benachbarten Teilzelle verbunden ist.

Eine weitere erfindungsgemäße Ausführungsform betrifft eine Mehrfachsolarzelle mit mindestens vier pn-Übergängen enthaltend eine erste, rückseitige und einen pn-Übergang aufweisende Germanium-Teilzelle, eine zweite und eine dritte Teilzelle aus III-V-Halbleitern sowie mindestens eine weitere, frontseitige Teilzelle aus III-V-Halbleitern, die dadurch gekennzeichnet ist, dass die zweite Teilzelle eine Gitterkonstante aufweist, die um mindestens 1 % größer ist als die Gitterkonstante aller anderen Teilzellen und die zweite Teilzelle mit der benachbarten Germanium-Teilzelle über eine metamorphe Pufferschicht zur Anpassung der Gitterkonstante der benachbarten Teilzellen und auf der gegenüberliegenden Seite über eine Waferbond-Verbindung mit den benachbarten Teilzellen verbunden ist.

Eine weitere erfindungsgemäße Ausführungsform betrifft eine Mehrfachsolarzelle mit mindestens vier pn-Übergängen enthaltend eine erste, rückseitige und einen pn-Übergang aufweisende Germanium-Teilzelle, eine zweite und eine dritte Teilzelle aus III-V-Halbleitern sowie mindestens eine weitere, frontseitige Teilzelle aus III-V-Halbleitern, die dadurch gekennzeichnet ist, dass die zweite Teilzelle eine Gitterkonstante aufweist, die um mindestens 1 % größer ist als die Gitterkonstante aller anderen Teilzellen und die zweite Teilzelle mit der benachbarten ersten Germanium-Teilzelle über eine metamorphe Pufferschicht zur Anpassung der Gitterkonstante der benachbarten Teilzellen und auf der gegenüberliegenden Seite über eine Waferbond-Verbindung mit den benachbarten Teilzellen verbunden ist.

Erfindungsgemäß kann somit eine Mehrfachsolarzelle durch Kombination von epitaktischem Wachstum auf zwei verschiedenen Substraten, metamorphem Wachstum und Waferbonding bereitgestellt werden. Drei der pn-Übergänge in dieser Struktur sind zur Germanium- bzw. Galliumarsenid-Teilzelle gitterangepasste Übergänge, da beide Kristalle eine sehr ähnliche Gitterkonstante aufweisen. Diese drei pn-Übergänge sind die frontseitige Teilzelle, die dritte Teilzelle und die rückseitige Germanium-Teilzelle. Zwischen diesen Teilzellen ist nun eine weitere Teilzelle (die zweite Teilzelle) mit einer Bandlückenenergie von 1,0 eV eingefügt. Diese zweite Teilzelle hat eine deutlich größere Gitterkonstante im Vergleich zu den Materialien der anderen Teilzellen. Für den Einbau der zweiten Teilzelle in die Mehrfachsolarzelle ist es erforderlich, dass die Gitterkonstante mit Hilfe eines metamorphen Puffers allmählich von der Gitterkonstante der dritten Teilzelle (z.B. GaAs) bis zur Gitterkonstante der zweiten Teilzelle (z.B. GaInAs) oder von der Gitterkonstante der ersten Teilzelle (z.B. Ge) bis zur Gitterkonstante der zweiten Teilzelle (z.B. GaInAs) verändert wird.

Vorzugsweise besteht die zweite Teilzelle aus Gallium-Indium-Arsenid (GaInAs), Gallium-Arsenid-Antimonid (GaAsSb), Gallium-Indium-Arsenid-Phosphid (GaInAsP) oder Aluminium-Gallium-Indium-Arsenid (AlGaInAs). Besonders bevorzugt handelt es sich hierbei um eine GaInAs-Teilzelle.

Handelt es sich bei der zweiten Teilzelle um eine Indium enthaltende Teilzelle, so liegt der Gehalt an Indium, bezogen auf den Gesamtgehalt an III-Halbleitern, bevorzugt im Bereich von 10 bis 80 Gew.-%, besonders bevorzugt im Bereich von 20 bis 50 Gew.-%.

Handelt es sich bei der zweiten Teilzelle um eine Antimon enthaltende Teilzelle, so liegt der Gehalt an Antimon, bezogen auf den Gesamtgehalt an V-Halbleitern, bevorzugt im Bereich von 13 bis 50 Gew.-%.

Vorzugsweise weist die zweite Teilzelle eine Bandlückenenergie zwischen 0,7 eV und 1,4 eV, besonders bevorzugt zwischen 0,9 eV und 1,1 eV auf. Die optimalsten Ergebnisse lassen sich mit einer zweiten Teilzelle mit einer Bandlückenenergie von 1,0 eV erzielen.

Eine weitere bevorzugte Ausführungsform sieht vor, dass die zweite Teilzelle eine Gitterkonstante aufweist, die um mindestens 1 %, bevorzugt um 2 bis 2,5 % größer ist als die Gitterkonstanten aller anderen Teilzellen.

Die metamorphe Pufferschicht besteht vorzugsweise aus Gallium-Indium-Antimonid (GaInAs), Aluminium-Gallium-Indium-Arsenid (AlGaInAs), Gallium-Indium-Phosphid (GaInP), Aluminium-Gallium-Indium-Phosphid (AlGaInP), Gallium-Arsenid-Antimonid (GaAsSb), Aluminium-Arsenid-Anitmonid (AlAsSb), Gallium-Phosphid-Anitmonid (GaPSb) oder Aluminium-Phosphid-Anitmonid (AlPSb) und kann je nach Lage der Tunneldioden entweder p- oder n-leitend ausgeführt sein, wobei die Gitterkonstante durch mehrere Schritte oder kontinuierlich von der Gitterkonstante der dritten Teilzelle (z.B. GaAs) bis zur Gitterkonstante der zweiten Teilzelle (z.B. GaInAs) oder von der Gitterkonstante der ersten Teilzelle (z.B. Ge) bis zur Gitterkonstante der zweiten Teilzelle (z.B. GaInAs) überführt wird.

Es ist weiter bevorzugt, dass die Waferbond-Verbindung zwischen den betroffenen Teilzellen elektrisch leitfähig und optisch transparent ist. Unter optischer Transparenz im Rahmen der vorliegenden Erfindung ist eine Transmission von mindestens 80 %, bevorzugt von mindestens 95 % bei Wellenlängen von mindestens 900 nm zu verstehen.

Die Waferbond-Verbindung kann je nach Lage der Tunneldioden zwischen zwei p-leitenden oder zwei n-leitenden Halbleiterschichten erfolgen, die bevorzugt eine hohe Dotierung aufweisen.

Hinsichtlich der weiteren Teilzellen sind grundsätzlich alle im Stand der Technik bekannten Materialien einsetzbar, die die Vorgaben hinsichtlich der Bandlückenenergie erfüllen.

Die dritte Teilzelle besteht vorzugsweise aus Gallium-Arsenid (GaAs), Gallium-Indium-Arsenid (GaInAs) oder Aluminium-Gallium-Indium-Arsenid (AlGaInAs). Die mindestens eine weitere, frontseitige Teilzelle besteht vorzugsweise aus Gallium-Indium-Phosphid (GaInP), Aluminium-Gallium-Arsenid (AlGaAs) oder Aluminium-Gallium-Indium-Phosphid (AlGaInP) oder enthält diese im Wesentlichen.

Bevorzugt wird eine Mehrfachsolarzelle mit vier Teilzellen bereitgestellt, wobei die vierte Teilzelle eine frontseitige Teilzelle darstellt. Ebenso ist es aber auch möglich, dass eine oder weitere Teilzellen zwischen der frontseitigen Teilzelle und der dritten Teilzelle angeordnet sind, woraus dann Mehrfachsolarzellen mit fünf oder mehr Teilzellen resultieren können.

Es ist weiter bevorzugt, dass die einzelnen Teilzellen weitere Funktionsschutzschichten aufweisen, insbesondere Tunneldioden zur elektrischen Verbindung der einzelnen Teilzellen, Barriereschichten an der Front- und Rückseite der Teilzellen, hochdotierte Kontaktschichten, interne Reflexionsschichten und/oder Antireflexschichten an der Vorderseite der Zelle.

Erfindungsgemäß werden ebenso Verfahren zur Herstellung der zuvor beschriebenen Mehrfachsolarzelle bereitgestellt. Hierbei gibt es grundsätzlich zwei verschiedene Ansätze:
1. Auf der ersten Germanium-Teilzelle wird die metamorphe Pufferschicht und die zweite Teilzelle aufgewachsen. Anschließend wird hiervon separat auf einem GaAs- oder Ge-Substrat die dritte Teilzelle aus III-V-Halbleitern sowie die mindestens eine weitere, frontseitige Teilzelle aufgewachsen und an der Frontseite auf einem Träger (z.B. aus Saphir) mittels ablösbarem Kleber stabilisiert. Diese beiden Teilzellenstrukturen werden dann zwischen der zweiten und dritten Teilzelle mittels Waferbonding verbunden. Anschließend werden der Träger und der Kleber entfernt.
2. Auf der ersten Germanium-Teilzelle wird die metamorphe Pufferschicht und die zweite Teilzelle aufgewachsen. Separat hiervon werden auf einem GaAs- oder Ge-Substrat die mindestens eine weitere, frontseitige Teilzelle und die dritte Teilzelle aus III-V-Halbleitern invertiert aufgewachsen. Diese beiden Teilzellenstrukturen werden im Anschluss zwischen der zweiten und dritten Teilzelle mittels Waferbonding verbunden. Abschließend wird das GaAs- oder Ge-Substrat abgelöst.

Neu an diesem Ansatz ist, dass eine GaInAs-Teilzelle mit einer optimalen Bandlückenenergien von 1,0 eV über Wafer-Bonding und mit metamorphem Pufferwachstum in eine herkömmliche Solarzellenstruktur aus GaInP/GaAs/Germanium integriert werden kann. Hierdurch kann die Wachstumsmethode der metallorganischen Gasphasenepitaxie mit ihren nachgewiesenen geringen Kosten verwendet werden. Weiterhin profitiert die Struktur von der hohen Strahlungsstabilität der Germanium-Unterzelle für die Weitraumanwendung. Die Prozessierung von Mehrfachsolarzellen auf Germanium ist weiterhin in der Industrie bereits etabliert, ebenso wie die Prozessierung der Vorderseite. Hiermit können bestehende Produktionsprozesse genutzt werden. Der beschriebene Ansatz ist besonders dann auch von den Kosten wirtschaftlich und interessant, wenn ein Ablöseverfahren für das GaAs-Substrat (notwendig zum Wachstum der oberen Teilzellen) gefunden werden kann, welches es erlaubt das Substrat mehrfach für das Wachstum zu recyceln.

Die erfindungsgemäßen Solarzellen können sowohl für die Weltraumanwendung als auch die Anwendung in terrestrischen Konzentratorsystemen eingesetzt werden.

Die vorliegende Erfindung bringt den Vorteil mit sich, dass etablierte Verfahren der metallorganischen Gasphasenepitaxie eingesetzt werden können, die auf epitaktischen Strukturen für GaInP, GaAs und Germanium basieren. Da auch die Herstellung der Kontakte auf der Rückseite der Germanium-Teilzelle und auf der Vorderseite bekannt und etabliert sind, kann so die herkömmliche Prozesskette beibehalten werden, so dass die erfindungsgemäße Mehrfachsolarzelle leicht in die bestehende Fertigungstechnologie integriert werden kann. Ein weiterer wesentlicher Vorteil besteht darin, dass die erfindungsgemäße Mehrfachsolarzelle einen sehr hohen Wirkungsgrad aufweist, da die Bandlückenenergien aller Teilzellen so eingestellt werden können, dass diese nahe am theoretischen Optimum liegen. Für die Weltraumanwendung ergibt sich ein weiterer Vorteil, da die Germaniumzelle eine hohe Strahlungsstabilität besitzt.

Anhand des nachfolgenden Beispiels und der Figuren soll der erfindungsgemäße Gegenstand näher erläutert werden, ohne diesen auf die hier gezeigten spezifischen Ausführungsformen einschränken zu wollen.
- Fig. 1: zeigt eine erste Ausführungsform der erfindungsgemäßen Mehrfachsolarzelle.
- Fig. 2: zeigt eine aus dem Stand der Technik bekannte Ausführungsform einer Mehrfachsolarzelle.
- Fig. 3: zeigt eine erfindungsgemäße Mehrfachsolarzelle mit einer Vielzahl zusätzlicher Funktionsschutzschichten, insbesondere Tunneldioden sowie Barriereschichten.
- Fig. 4: zeigt eine Transmissionselektronenmikroskopaufnahme der erfindungsgemäßen Pufferschicht, in welcher die Gitterkonstante von Ge bis hin zu Ga_{0.71}In_{0.29}As verändert wird.
- Fig. 5: zeigt eine erfindungsgemäße Waferbond-Verbindung zwischen zwei Halbleitern mit unterschiedlicher Gitterkonstanten.

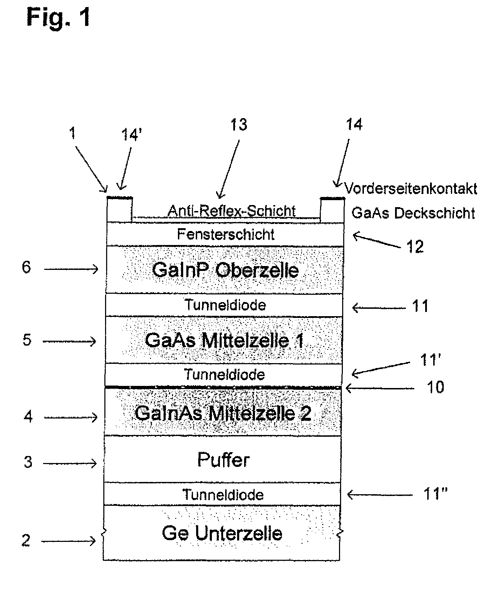

In Fig. 1 ist eine Mehrfachsolarzelle 1 mit einer rückseitigen Germanium-Teilzelle 2 dargestellt. Auf diese Teilzelle ist ein metamorpher Puffer 3 und die zweite Teilzelle aus GaInAs gewachsen. Die zweite Teilzelle ist mit einer dritten Teilzelle 5 aus Galliumarsenid über ein Waferbonding 10 verbunden. Die Mehrfachsolarzelle weist eine weitere frontseitige Teilzelle 6 aus GaInP auf. Weiterhin sind Tunneldioden 11, 11' und 11" zur elektrischen Verbindung der Teilzellen in die Mehrfachsolarzelle integriert. Frontseitig weist die Mehrfachsolarzelle eine Fensterschicht 12, eine Antireflexschicht 13 sowie Vorderseitenkontakte 14 und 14' auf.

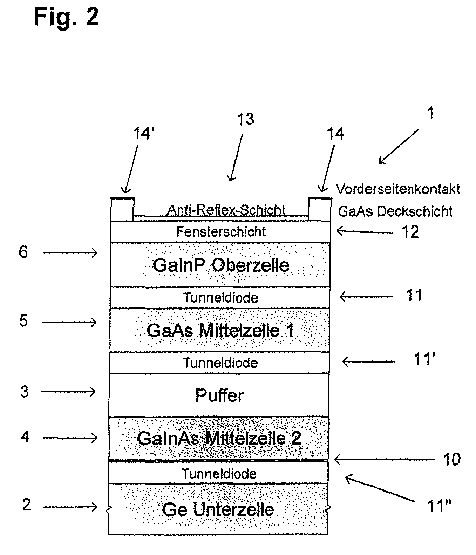

In Fig. 2 ist eine aus dem Stand der Technik bekannte Ausführungsform einer Mehrfachsolarzelle 1 dargestellt. Diese Mehrfachsolarzelle basiert auf dem invertierten Wachstum der Struktur. Dabei wird der obere Teil der Mehrfachsolarzelle 1, d.h. die Teilzelle 6 aus GaInP und die Teilzelle 5 aus GaAs zunächst auf einem Substrat aus Galliumarsenid invertiert gewachsen. Anschließend wird der metamorphe Puffer 3 und die zweite Teilzelle 4 aus GaInAs gewachsen. Der metamorphe Puffer 3 dient dabei der Überführung der Gitterkonstante von GaAs zu GaInAs. Die rückseitige Germanium-Teilzelle 2 wird separat hergestellt und anschließend mit der invertiert gewachsenen Solarzellenstruktur aus GaInP/GaAs/GaInAs über den Wafer-Bond 10 verbunden. Weiterhin sind in die Mehrfachsolarzelle 1 Tunneldioden 11, 11' und 11" zur elektrischen Verbindung der Metallzellen integriert. Die Mehrfachsolarzelle 1 weist weiterhin eine Fensterschicht 12, eine Antireflexschicht 13 sowie Vorderseitenkontakte 14 und 14' auf.

### Beispiel

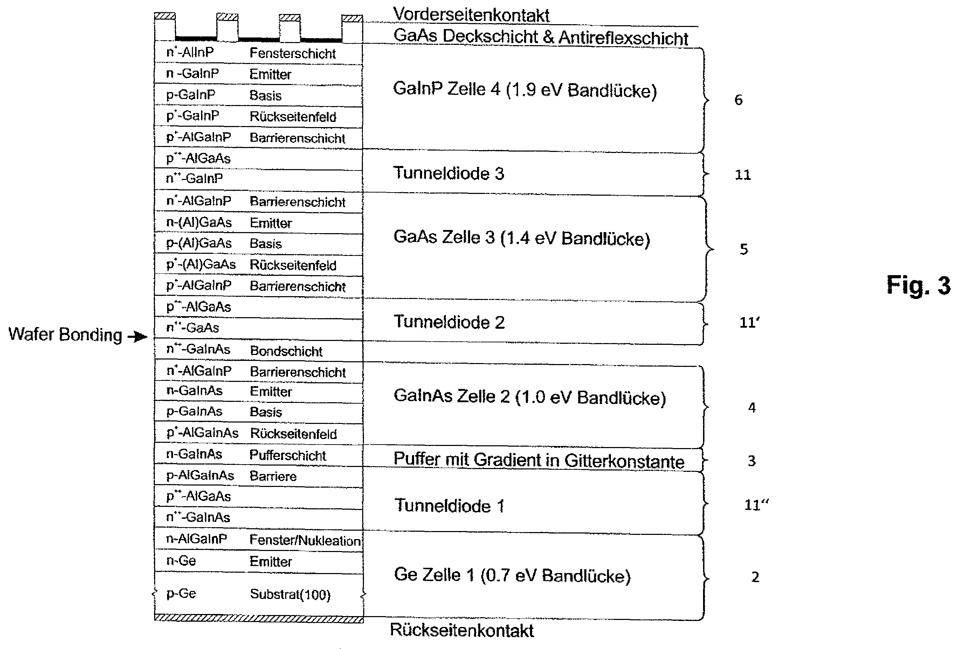

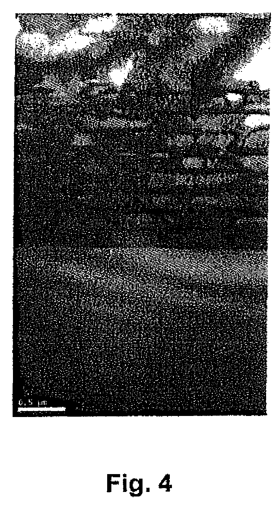

Eine erfindungsgemäße Mehrfachsolarzelle 1 ist in Fig. 3 gezeigt. Hierbei wird zunächst eine Schichtfolge auf Ge mit einer Gitterkonstanten von 5.65 Angström hergestellt. Hierzu wird die Ge Teilzelle 1 durch Diffusion und Aufwachsen einer AlGaInP Fensterschicht im MOVPE Reaktor erzeugt. Auf die Ge Teilzelle 2 wird eine Tunneldiode 11" aus entarteten n- und p-leitenden Halbleiterschichten gewachsen. Die Tunneldioden kann von weiteren Barrierenschichten mit höherer Bandlückenenergie umgeben sein. Danach folgt eine GaInP Pufferschicht 3, in welcher die Gitterkonstante von Ge bis hin zu Ga_{0.71}In_{0.29}As mit einer Bandlückenenergie von 1.0 eV übergeführt wird. Eine Transmissionselektronenmikroskopieaufnahme einer solchen Pufferschicht ist in Fig. 4 gezeigt. Aufgrund des Unterschieds in der Gitterkonstante von 2.3 % entstehen Fehlanpassungsversetzungen, welche horizontal durch die Pufferschicht laufen. Diese sind als dunkle Linien in der TEM Aufnahme zu sehen. Durch eine geeignete Wahl der Wachstumsbedingungen kann die Dichte an durchstoßenden Versetzungen so gering gehalten werden, dass sich noch Solarzellen mit guter Qualität auf den Pufferschichten herstellen lassen. Nach der Pufferschicht wird die Ga_{0.71}In_{0.29}As Teilzelle 4 mit einer Gitterkonstanten von
5.78 Angström epitaxiert. Die Teilzelle besteht aus einer p-leitenden Basis, einem n-leitenden Emitter und weiteren Barriereschichten für Minoritätsladungsträger an der Vorderseite und Rückseite. Auf die Ga_{0.71}In_{0.29}As Teilzelle 4 folgt eine hochdotierte n-Ga_{0.71}In_{0.29}As Bondschicht.

Eine zweite Schichtfolge wird auf einem separaten GaAs oder Ge Substrat abgeschieden. Diese enthält zunächst eine Ablöseschicht, welche später dazu genutzt werden kann das Substrat von der Solarzellenstruktur zu trennen. Ein Beispiel ist eine AlAs Zwischenschicht, welche sich in Flusssäure selektiv zu den übrigen Schichten ätzen lässt. Darauf folgen eine GaAs Kontaktschicht mit hoher Dotierung, eine Teilzelle 6 aus Ga_{0.5}In_{0.5}P, eine Tunneldiode 11, eine GaAs oder AIGaAs Teilzelle 5 und eine Tunneldiode 11'. Die Teilzellen und Tunneldioden können wie bei der Teilzelle 4 und der Tunneldiode 11" zusätzliche Barriereschichten mit höherer Bandlückenenergie enthalten. Alle Halbleiterschichten der Schichtfolge sind gitterangepasst zueinander und besitzen eine Gitterkonstante von etwa 5.65 Angström.

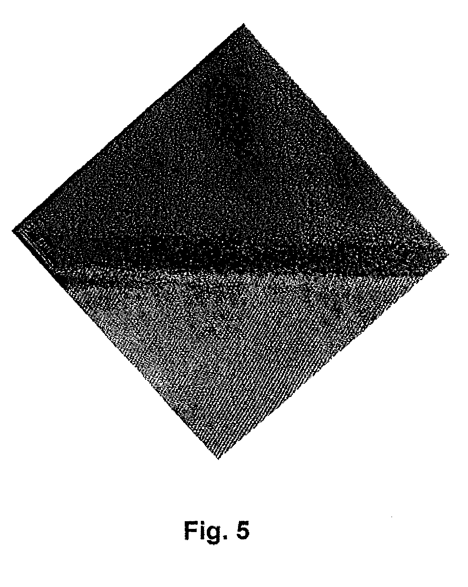

Die beiden Schichtstrukturen werden nun über einen Wafer-Bond miteinander verbunden. Hierbei eignet sich besonders ein direkter Bond, welcher die Eigenschaften von Transparenz und sehr guter Leitfähigkeit erfüllt. In einem möglichen Prozess werden die beiden Schichtstrukturen im Vakuum unter dem Beschuss mit Ar-Atomen deoxidiert. Dabei entsteht eine 1-3 nm dünne amorphe Schicht an der Oberfläche. Die beiden Schichtstrukturen werden anschließend bei Raumtemperatur unter einem Druck von 5-10 kNewton miteinander verpresst. Zur Erhöhung der Bondenergie kann ein weiteres Ausheizen bei Temperaturen von 100 - 500 °C notwendig sein. Weiter ist es notwendig die Oberfläche der Schichtstrukturen zu polieren, falls die Oberflächenrauigkeit schlechter als 1 nm ist. Ein solcher direkter Wafer Bond zwischen zwei Halbleitern mit unterschiedlicher Gitterkonstante ist in Fig. 5 in einer Transmissionselektronenmikroskopieaufnahme gezeigt. Man sieht die amorphe Zwischenschicht an der Bond-Grenzfläche.

Nach dem Wafer-Bonden wird das GaAs bzw. Ge Substrat von der Schichtstruktur entfernt und die Solarzelle mit Kontakten und Antireflexschichten prozessiert.

Die Forschungsarbeiten, die zu diesen Ergebnissen geführt haben, wurden von der Europäischen Union gefördert.

## Patentansprüche

1. Mehrfachsolarzelle mit mindestens vier pn-Übergängen enthaltend eine erste, rückseitige und einen pn-Übergang aufweisende Germanium-Teilzelle (2), eine zweite und eine dritte Teilzelle (4,5) aus III-V-Halbleitern sowie mindestens eine weitere, frontseitige Teilzelle aus III-V-Halbleitern, wobei die zweite Teilzelle (4) eine Gitterkonstante aufweist, die um mindestens 1 % größer ist als die Gitterkonstante aller anderen Teilzellen,
**dadurch gekennzeichnet, dass** die zweite Teilzelle (4) mit der benachbarten ersten Germanium-Teilzelle (2) über eine metamorphe Pufferschicht (3) zur Anpassung der Gitterkonstante der benachbarten Teilzellen und auf der gegenüberliegenden Seite über eine Waferbond-Verbindung (10) mit der benachbarten dritten Teilzelle (5) verbunden ist.

2. Mehrfachsolarzelle nach Anspruch 1,
**dadurch gekennzeichnet, dass** die zweite Teilzelle (4) aus GaInAs, GaInAsP oder AlGaInAs, bevorzugt mit einem Gehalt an Indium, bezogen auf die Gruppe-III Elemente, von 10 % bis 80 %, besonders bevorzugt von 20 % bis 50 %, oder GaAsSb, bevorzugt mit einem Gehalt an Antimon, bezogen auf die Gruppe-V Elemente, von 13 % bis 50 %, besteht.

3. Mehrfachsolarzelle nach einem der vorhergehenden Ansprüche,
**dadurch gekennzeichnet, dass** die zweite Teilzelle (4) eine Bandlückenenergie zwischen 0,7 eV und 1,4 eV besitzt, bevorzugt zwischen 0,9 eV und 1,1 eV aufweist.

4. Mehrfachsolarzelle nach einem der vorhergehenden Ansprüche,
**dadurch gekennzeichnet, dass** die zweite Teilzelle (4) eine Gitterkonstante aufweist, die um 1,5 % bis 3 %, insbesondere um 2 % bis 2,5 % größer ist als die Gitterkonstanten aller anderen Teilzellen.

5. Mehrfachsolarzelle nach einem der vorhergehenden Ansprüche,
**dadurch gekennzeichnet, dass** die metamorphe Pufferschicht (3) aus GaInAs, AlGaInAs, GaInP, AlGaInP, GaAsSb, AlAsSb, GaPSb oder AlPSb besteht.

6. Mehrfachsolarzelle nach einem der vorhergehenden Ansprüche,
**dadurch gekennzeichnet, dass** die Waferbond-Verbindung (10) elektrisch leitfähig und optisch transparent ist.

7. Mehrfachsolarzelle nach einem der vorhergehenden Ansprüche,
**dadurch gekennzeichnet, dass** die dritte Teilzelle (5) aus GaAs, GaInAs oder AlGaInAs besteht.

8. Mehrfachsolarzelle nach einem der vorhergehenden Ansprüche,
**dadurch gekennzeichnet, dass** die mindestens eine weitere Teilzelle aus GaInP, AlGaAs oder AlGaInP besteht oder diese im Wesentlichen enthält.

9. Mehrfachsolarzelle nach einem der vorhergehenden Ansprüche,
**dadurch gekennzeichnet, dass** die mindestens eine weitere Teilzelle (6) aus einer frontseitige Teilzelle (6) und gegebenenfalls mindestens einer zwischen der dritten und der frontseitigen Teilzelle angeordneten Teilzelle besteht.

10. Mehrfachsolarzelle nach einem der vorhergehenden Ansprüche,
**dadurch gekennzeichnet, dass** die einzelnen Teilzellen weitere Funktionsschutzschichten aufweisen, insbesondere Tunneldioden (11, 11', 11") zur elektrisch Verbindung der einzelnen Teilzellen, Barriereschichten an der Front- und Rückseite der Teilzellen, hochdotierte Kontaktschichten (14, 14'), interne Reflexionsschichten und/oder Antireflexschichten (13) an der Vorderseite der Zelle.

11. Verfahren zur Herstellung einer mit den vorherigen Ansprüchen beanspruchten Merhfachsolarzelle,
bei dem
a) auf der ersten Germanium-Teilzelle (2) die metamorphe Pufferschicht (3) und die zweite Teilzelle (4) aufgewachsen wird,
b) auf einem GaAs- oder Ge-Substrat die dritte Teilzelle (5) aus III-V-Halbleitern sowie die mindestens eine weitere, frontseitige Teilzelle aufgewachsen, anschließend die Struktur an der Frontseite durch einen Träger, z.B. aus Saphir, mittels ablösbarem Kleber stabilisiert und das GaAs- oder Ge-Substrat entfernt werden
c) die Teilzellenstrukturen aus a) und b) zwischen der zweiten und dritten Teilzelle (4, 5) mittels Waferbonding (10) verbunden werden,
d) der Träger und der Klebstoff entfernt werden,
**dadurch gekennzeichnet, dass** die zweite Teilzelle (4) mit einer Gitterkonstante aufgewachsen wird, die um mindestens 1 % größer ist als die Gitterkonstanten aller anderen Teilzellen.

12. Verfahren zur Herstellung einer mit den Ansprüchen 1-10 beanspruchten Mehrfachsolarzelle,
bei dem
a) auf der ersten Germanium-Teilzelle (2) die metamorphe Pufferschicht (3) und die zweite Teilzelle (4) aufgewachsen wird,
b) auf einem GaAs- oder Ge-Substrat die mindestens eine weitere, frontseitige Teilzelle und anschließend die dritte Teilzelle (5) aus III-V-Halbleitern invertiert aufgewachsen werden,
c) die Teilzellenstrukturen aus a) und b) zwischen der zweiten und dritten Teilzelle (4, 5) mittels Waferbonding (10) verbunden werden,
d) nach dem Waferbonding (10) das GaAs- oder Ge-Substrat abgelöst wird,
**dadurch gekennzeichnet, dass** die zweite Teilzelle (4) mit einer Gitterkonstante aufgewachsen wird, die um mindestens 1 % größer ist als die Gitterkonstanten aller anderen Teilzellen.

13. Verfahren nach einem der Ansprüche 11 oder 12,
**dadurch gekennzeichnet, dass** das Aufwachsen der zweiten Teilzelle (4), der dritten Teilzelle (5) und der mindestens einen weiteren, frontseitigen Teilzelle epitaktisch und das Aufwachsen der metamorphen Pufferschicht (3) metamorph erfolgt.

14. Verwendung der mit einem der Ansprüche 1 bis 10 beanspruchten Mehrfachsolarzelle im Weltraum oder in terrestrischen Konzentratorsystemen.

## Claims

1. Multi-junction solar cell having at least four p-n junctions containing a first, rear germanium partial cell (2) having a p-n junction, a second and third partial cell (4, 5) made from III-V semiconductors as well as at least one further, front-side partial cell made from III-V semiconductors, wherein the second partial cell (4) has a lattice constant which is at least 1% larger than the lattice constant of all other partial cells,
**characterised in that** the second partial cell (4) is connected to the adjacent first germanium partial cell (2) via a metamorphic buffer layer (3) for the adjustment of the lattice constant of the adjacent partial cells and on the opposite side to the adjacent third partial cell (5) via a wafer bonding connection (10).

2. Multi-junction solar cell according to claim 1,
**characterised in that** the second partial cell (4) consists of GalnAs, GalnAsP or AlGalnAs, preferably having an indium content, with regard to the group III elements, from 10% to 80%, particularly preferably from 20% to 50%, or GaAsSb, preferably having an antimony content, with regard to the group V elements, from 13% to 50%.

3. Multi-junction solar cell according to one of the preceding claims,
**characterised in that** the second partial cell (4) has a band gap energy of between 0.7 eV and 1.4 eV, preferably between 0.9 eV and 1.1 eV.

4. Multi-junction solar cell according to one of the preceding claims,
**characterised in that** the second partial cell (4) has a lattice constant which is 1.5% to 3%, in particular 2% to 2.5%, larger than the lattice constants of all other partial cells.

5. Multi-junction solar cell according to one of the preceding claims,
**characterised in that** the metamorphic buffer layer (3) consists of GalnAs, AlGalnAs, GalnP, AlGalnP, GaAsSb, AlAsSb, GaPSb or AlPSb.

6. Multi-junction solar cell according to one of the preceding claims,
**characterised in that** the wafer bonding connection (10) is electrically conductive and visually transparent.

7. Multi-junction solar cell according to one of the preceding claims,
**characterised in that** the third partial cell (5) consists of GaAs, GalnAs or AlGalnAs.

8. Multi-junction solar cell according to one of the preceding claims,
**characterised in that** the at least one further partial cell consists of GalnP, AlGaAs or AlGalnP or substantially contains these.

9. Multi-junction solar cell according to one of the preceding claims,
**characterised in that** the at least one further partial cell (6) consists of a front-side partial cell (6) and optionally at least one partial cell arranged between the third and front-side partial cells.

10. Multi-junction solar cell according to one of the preceding claims,
**characterised in that** the individual partial cells have further function protection layers, in particular tunnel diodes (11, 11', 11 ") for the electrical connection of the individual partial cells, barrier layers on the front and rear sides of the partial cells, highly doped contact layers (14, 14'), internal reflection layers and/or anti-reflection layers (13) on the front side of the cell.

11. Method for the production of a multi-junction solar cell claimed with the preceding claims,
wherein
a) the metamorphic buffer layer (3) and the second partial cell (4) are grown on the first germanium partial cell (2),
b) the third partial cell (5) made from III-V semiconductors as well as the at least one further, front-side partial cell are grown on a GaAs or Ge substrate, then the structure is stabilised on the front side by a carrier, for example made from sapphire, by means of detachable adhesive and the GaAs or Ge substrate is removed,
c) the partial cell structures from a) and b) are connected between the second and third partial cells (4, 5) by means of wafer bonding (10),
d) the carrier and the adhesive are removed,
**characterised in that** the second partial cell (4) is grown with a lattice constant which is at least 1% larger than the lattice constants of all other partial cells.

12. Method for the production of a multi-junction solar cell claimed with claims 1 to 10,
wherein
a) the metamorphic buffer layer (3) and the second partial cell (4) are grown on the first germanium partial cell (2),
b) the at least one further, front-side partial cell and subsequently the third partial cell (5) made from III-V semiconductors are grown in an inverted manner on a GaAs or Ge substrate,
c) the partial cell structures from a) and b) are connected between the second and third partial cells (4, 5) by means of wafer bonding (10),
d) the GaAs or Ge substrate is detached after wafer bonding (10),
**characterised in that** the second partial cell (4) is grown with a lattice constant which is at least 1% larger than the lattice constants of all other partial cells.

13. Method according to one of claims 11 or 12,
**characterised in that** the growth of the second partial cell (4), the third partial cell (5) and the at least one further, front-side partial cell takes place epitaxially and the growth of the metamorphic buffer layer (3) takes place metamorphically.

14. Use of the multi-junction solar cell claimed with one of claims 1 to 10 in space or in terrestrial concentrator systems.

## Revendications

1. Cellule solaire multiple comportant au moins quatre transitions pn, contenant une première cellule partielle (2) au germanium, côté arrière et comprenant une transition pn, une deuxième et une troisième cellules partielles (4, 5) en semi-conducteurs III-V, ainsi qu'au moins une cellule partielle supplémentaire côté avant, constituée de semi-conducteurs III-V, la deuxième cellule partielle (4) présentant une constante de réseau qui est d'au moins 1 % plus grande que la constante de réseau de toutes les autres cellules partielles, **caractérisée en ce que** la deuxième cellule partielle (4) est assemblée à la première cellule partielle voisine au germanium (2) par l'intermédiaire d'une couche tampon métamorphique (3), pour adapter la constante de réseau des cellules partielles voisines, et, sur le côté opposé, est assemblée à la troisième cellule partielle voisine (5) par l'intermédiaire d'un assemblage Waferbond (10).

2. Cellule solaire multiple selon la revendication 1, **caractérisée en ce que** la deuxième cellule partielle (4) est constituée de GaInAs, de GaInAsP ou d'AlGaInAs, avec de préférence une teneur en indium, rapportée aux éléments du Groupe III, de 10 % à 80 %, tout préférablement de 20 % à 50 %, ou de GaAsSb, avec de préférence une teneur en antimoine, rapportée aux éléments du Groupe V, de 13 % à 50 %.

3. Cellule solaire multiple selon l'une des revendications précédentes, **caractérisée en ce que** la deuxième cellule partielle (4) présente une énergie de bande interdite comprise entre 0,7 eV et 1,4 eV, de préférence entre 0,9 eV et 1,1 eV.

4. Cellule solaire multiple selon l'une des revendications précédentes, **caractérisée en ce que** la deuxième cellule partielle (4) présente une constante de réseau qui est de 1,5 à 3 %, en particulier de 2 % à 2,5 %, plus grande que les constantes de réseau de toutes les autres cellules partielles.

5. Cellule solaire multiple selon l'une des revendications précédentes, **caractérisée en ce que** la couche tampon métamorphique (3) est constituée de GaInAs, d'AlGaInAs, de GaInP, d'AlGaInP, de GaAsSb, d'AlAsSb, de GaPSb ou d'AlPsB.

6. Cellule solaire multiple selon l'une des revendications précédentes, **caractérisée en ce que** l'assemblage Waferbond (10) est électriquement conducteur et optiquement transparent.

7. Cellule solaire multiple selon l'une des revendications précédentes, **caractérisée en ce que** la troisième cellule partielle (5) est constituée de GaAs, de GaInAs ou d'AlGaInAs.

8. Cellule solaire multiple selon l'une des revendications précédentes, **caractérisée en ce que** la ou les cellules partielles supplémentaires sont constituées de GaInP, d'AlGaAs ou d'AlGaInP, ou les contiennent pour l'essentiel.

9. Cellule solaire multiple selon l'une des revendications précédentes, **caractérisée en ce que** la ou les cellules partielles supplémentaires (6) sont constituées d'une cellule partielle (6) côté avant et éventuellement d'au moins une cellule partielle disposée entre la troisième cellule partielle et la cellule partielle côté avant.

10. Cellule solaire multiple selon l'une des revendications précédentes, **caractérisée en ce que** les cellules partielles individuelles présentent des fonctions supplémentaires de protection fonctionnelle, en particulier des diodes tunnel (11, 11', 11"), pour une liaison électrique des cellules partielles individuelles, des couches barrière sur le côté avant et le côté arrière des cellules partielles, des couches de contact hautement dopées (14, 14'), des couches de réflexion internes et/ou des couches anti-réfléchissantes (13) sur le côté avant de la cellule.

11. Procédé de fabrication d'une cellule solaire multiple revendiquée par les revendications précédentes, dans lequel
a) on fait croître sur la première cellule partielle en germanium (2) la couche tampon métamorphique (3) et la deuxième cellule partielle (4),
b) on fait croître sur un substrat de GaAs ou de Ge la troisième cellule partielle (5) en semi-conducteurs III-V, ainsi que la ou les cellules partielles supplémentaires côté avant, puis on stabilise la structure sur le côté avant grâce à un support, par exemple en saphir, à l'aide d'un adhésif détachable, et on élimine le substrat de GaAs ou de Ge,
c) on relie par assemblage Waferbond (10) les structures de cellules partielles a) et b) entre la deuxième et la troisième cellules partielles (4, 5),
d) on élimine le support et l'adhésif,
**caractérisé en ce qu'**on fait croître la deuxième cellule partielle (4) avec une constante de réseau qui est d'au moins 1 % plus grande que les constantes de réseau de toutes les autres cellules.

12. Procédé de fabrication d'une cellule solaire multiple revendiquée par les revendications 1 à 10, dans lequel,
a) on fait croître sur la première cellule partielle en germanium (2) la couche tampon métamorphique (3) et la deuxième cellule partielle (4),
b) on fait croître sur un substrat de GaAs ou de Ge la ou les cellules partielles supplémentaires côté avant, puis d'une manière inversée la troisième cellule partielle (5) en semi-conducteurs III-V,
c) on assemblage par Waferbond (10) les structures de cellules partielles de a) et de b) entre la deuxième et la troisième cellules partielles (4, 5),
d) après l'assemblage Waferbond (10), on détache le substrat de GaAs ou de Ge,
**caractérisé en ce qu'**on fait croître la deuxième cellule partielle (4) avec une constante de réseau qui est d'au moins 1 % plus grande que les constantes de réseau de toutes les autres cellules partielles.

13. Procédé selon l'une des revendications 11 ou 12, **caractérisé en ce que** la croissance de la deuxième cellule partielle (4), de la troisième cellule partielle (5) et de la ou des cellules partielles supplémentaires côté avant, est réalisée d'une manière épitactique, et la croissance de la couche tampon métamorphique (3) a lieu d'une manière métamorphique.

14. Utilisation de la cellule solaire multiple revendiquée par l'une des revendications 1 à 10, dans l'espace ou dans des systèmes concentrateurs terrestres.
